# EUROPEAN PATENT APPLICATION

(11) **EP 1 109 276 A2**
(43) Date of publication of application: **20.06.2001**
(21) Application number: 00310963.4
(22) Date of filing: 08.12.2000
(51) Int. Cl.: H01S 5/068, H01S 5/06

(54) **Method and apparatus for stabilizing laser wavelength**

(30) Priority: 16.12.1999 US 464199
(71) Applicant: LUCENT TECHNOLOGIES INC., Murray Hill, New Jersey 07974-0636 (US)
(72) Inventor: Snyder, David A., Coopersburg, PA 18036 (US); Stayt Jr.,John W., Schnecksville, PA 18078 (US)
(74) Representative: Perkins, Sarah

(57) **Abstract**

A unique method and apparatus for the determination of the wavelength of a laser output in a multi- or stepped-etalon laser wavelength stabilization system is disclosed. Determination of the laser frequency is based on signals from each etalon path in the system, thereby compensating for subsequent changes in the optical characteristics of the etalons caused by varying temperatures. A corrective offset for the measured frequency of the laser output is determined based on values measured by each etalon and values previously stored in a look-up table. The frequency measurement is then adjusted by the determined offset to provide a more accurate determination of the laser frequency.

## Description

### Field Of The Invention

The present invention relates generally to tunable lasers and other tunable optical signal sources and more particularly to a method and system for laser wavelength stabilization utilizing multiple or stepped etalons.

### Description of the Related Art

Optical fiber communications systems provide for low loss and very high information carrying capacity. In practice, the bandwidth of optical fiber may be utilized by transmitting many distinct channels simultaneously using different carrier wavelengths. The wavelengths of the various channels used in communication systems have been standardized by the International Telecommunications Union (ITU) grid. The ITU grid includes frequencies from approximately 191,900 GHz to 195,800 GHz with a separate channel occurring approximately every 100 GHz. The associated technology is called wavelength division multiplexing (WDM). Dense WDM or DWDM systems offer 25 to 50 GHz channel spacing.

The wavelength bandwidth that any individual channel occupies depends on a number of factors, including the impressed information bandwidth, and margins to accommodate carrier frequency drift, carrier frequency uncertainty, and to reduce possible inter-channel cross-talk due to non-ideal filters.

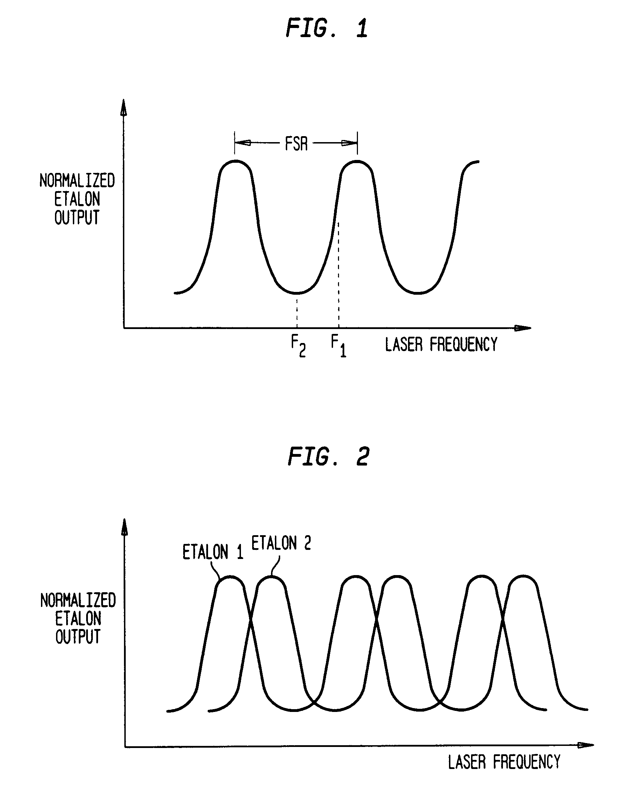

To maximize the number of channels, lasers with stable and precise wavelength control are required to provide narrowly spaced, multiple wavelengths. Various approaches have been used to limit the oscillation of a laser to a single channel. One approach is a distributed feedback mechanism. Distributed-feedback (DFB) lasers are the most common type of communications laser. A grating integral to the laser structure limits the output to a single frequency. Another of the most common methods is temperature tuning, which requires the use of a frequency selective external cavity/etalon in combination with such a laser device to detect the output wavelength, based on the etalon's response curve, at which the laser is operating. A typical etalon response curve is illustrated in Fig. 1. The laser frequency can be determined based on the normalized etalon output and adjusted accordingly by varying the temperature of the laser. Such a method allows for wavelength locking of a laser even in the event of changing ambient temperature conditions. The frequency difference between peaks of the etalon response curve is also known as the free spectral range (FSR). The FSR for an etalon of approximately 1 mm thickness is approximately 100 GHz, thus coinciding with the approximate spacing of the channels specified on the ITU grid.

To provide better discrimination between different wavelength channels and thus more efficient tuning, it is preferable to have an etalon in the optical package such that the location of the response curve where the slope is greatest corresponds with the desired channel. Thus, for example, an etalon with the response curve as illustrated in Fig. 1 would be better suited to lock on a channel with a frequency F1 over a channel with a frequency F2. However, it is difficult to ensure that the etalon in the optical package will have a response curve that will align with the desired channel of the transmission grid. To alleviate this problem, it is known to use a stepped etalon or multiple etalons of slightly different length in the optical package. Due to size constraints of the optical package, the number of etalons is typically limited to two. Having two etalons (or a single stepped etalon) results in response curves shifted relative to one another as illustrated in Fig. 2, thereby ensuring that at least one of the response curves will be sufficiently aligned with the ITU grid as described above. In practice, etalons are chosen such that the response curves are displaced relative to one another by approximately one-third of a FSR. Thus, any angular misalignment of the etalon can be accounted for by determining during manufacture and reliability testing the etalon (or portion of the etalon for a stepped etalon) whose response is most propitiously located relative to the ITU grid and choosing the corresponding etalon path for use during subsequent measuring of the laser frequency/wavelength.

There are problems, however, with the use of a stepped or multiple etalon for determining laser frequency as described above. For example, once the etalon path for use during subsequent measuring the laser output is chosen, the system is set for this path and can not be changed without removing the system from the end product and re-testing the system.

To keep the optical package compact, the etalon and laser are typically located on the same substrate. As noted previously, the lasing wavelength of the laser is changed by adjusting the temperature of the laser, which also results in a change of temperature of the substrate on which the etalon is mounted as well. As the laser ages, or when the laser is operated at different drive currents, it will necessarily have a different required operating temperature. As the temperature of the substrate is adjusted, so too will the temperature of the etalon vary, resulting in a change in its optical characteristics. As the optical characteristics of the etalon chosen to determine the frequency of the laser change, the etalon will thus no longer be properly aligned with respect to the ITU grid. This can result in erroneous measurements and consequently erroneous adjustment of the laser output, making it difficult to lock on a channel on the ITU grid.

Thus, there exists a need for a method and apparatus for determining and stabilizing a laser wavelength in a system which utilizes multiple etalons that can compensate for subsequent changes in the optical characteristics of the etalons caused by varying temperatures.

### Summary Of The Invention

The present invention overcomes some of the problems associated with the prior art by providing a unique method and apparatus for compensating for temperature change of an etalon in a multi- or stepped-etalon laser wavelength stabilization system.

In accordance with the present invention, the determination of the wavelength of a laser output in a multi- or stepped-etalon laser wavelength stabilization system is performed based on signals from each etalon path in the system, thereby compensating for subsequent changes in the optical characteristics of the etalons caused by varying temperatures. A corrective offset for the measured frequency of the laser output is determined based on values measured by each etalon and values previously stored in a look-up table. The frequency measurement is then adjusted by the determined offset to provide a more accurate determination of the laser frequency.

These and other advantages and features of the invention will become apparent from the following detailed description of the invention which is provided in connection with the accompanying drawings.

### Brief Description Of The Drawings

FIGURE 1 illustrates a typical etalon response curve;
FIGURE 2 illustrates response curves for a pair of etalons shifted relative to one another;
FIGURE 3 illustrates in block diagram form a portion of a system that utilizes a stepped etalon for measuring and stabilizing a laser frequency/wavelength in accordance with the present invention; and
FIGURES 4A and 4B illustrate in flowchart form a method for determining a laser frequency in accordance with the present invention.

### Detailed Description

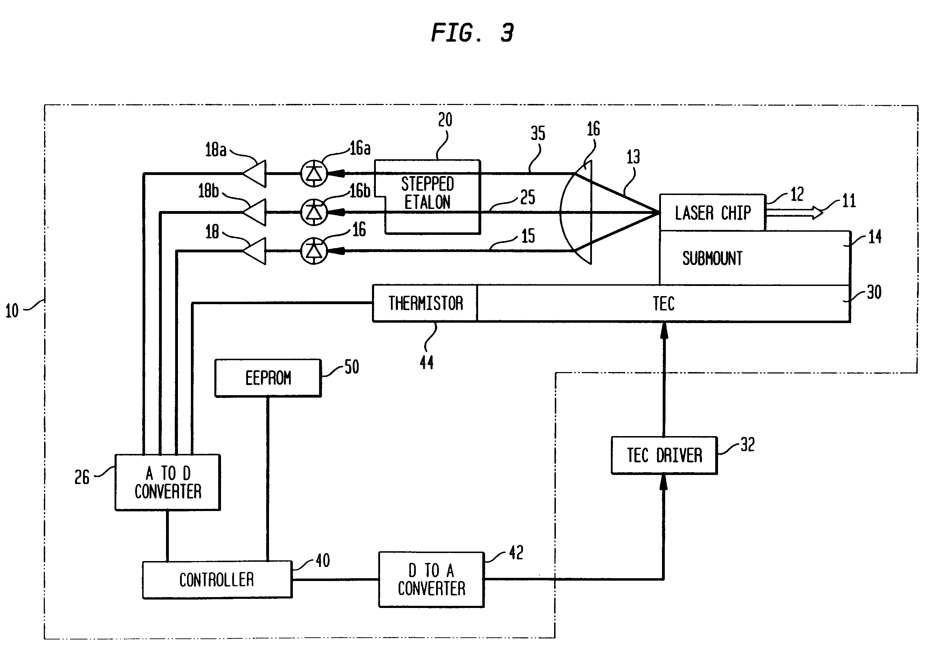

The present invention will be described as set forth in the embodiments illustrated in Figs. 3-4. Other embodiments may be utilized and structural, logical or programming changes may be made without departing from the spirit or scope of the present invention. Like items are referred to by like reference numerals throughout the description.

In accordance with the present invention, the determination of the frequency/wavelength of a laser output in a multi- or stepped-etalon laser wavelength stabilization system is performed based on signals from each etalon path in the system, thereby compensating for subsequent changes in the optical characteristics of the etalons caused by varying temperatures.

Fig. 3 illustrates in block diagram form a portion of a system that utilizes a stepped etalon for measuring and stabilizing a laser wavelength in accordance with the present invention. More specifically, Fig. 3 illustrates a control circuit 10 for a temperature tuned laser system that utilizes a stepped etalon for measuring the laser frequency in accordance with the present invention. It is to be understood that while control circuit 10 is illustrated as a single circuit, the invention is not so limited and the components of control circuit 10 may be provided as separate circuits connected together.

Control circuit 10 includes a laser chip 12 mounted on a Thermo-Electric Cooler (TEC) 30. A submount 14 between the laser chip 12 and the TEC 30 can be used if desired for thermal expansion matching. As is known in the art for temperature tuned lasers, the output of laser chip 12 can be adjusted by modifying the temperature of laser chip 12, as a laser chip will have an output directly related to its operating temperature. The temperature of laser chip 12 can be adjusted by varying the temperature of TEC 30. The temperature of TEC 30 is varied based on an input signal to TEC Driver 32 from a controller 40 through a digital to analog (D/A) converter 42. Controller 40 may include a programmable logic device, one example being a microprocessor. If a microprocessor is used, it may be any conventional general purpose single- or multi-chip microprocessor, or may be any conventional special purpose microprocessor such as a digital signal processor. Analog signal conditioning techniques may also be applied to the analog signals entering or exiting the A/D and D/A converters 26, 42. A memory device 50, such as for example an Electrically Erasable Programmable Read Only Memory (EEPROM) is connected to controller 40.

Controller 40 monitors and controls the output of laser chip 12 as follows. Laser chip 12 generates a laser output 11 and a backface output 13. The backface output 13 from laser chip 12 is input to a lens/optical splitter 16 to split the output into separate outputs 15, 25, 35. The first output 15, hereinafter referred to as the reference path, is input to a photodetector 16, as is known in the art, to convert the laser from an optical signal to an electrical signal. The converted electrical signal is input to an amplifier circuit 18. The output from amplifier circuit 18 is converted from an analog signal to a digital signal by analog to digital (A/D) converter 26 and input to controller 40.

The second output 25 and third output 35, hereinafter referred to as the etalon paths, are input to a stepped etalon filter 20 as is known in the art. Alternatively, the paths 25, 35 may be input to multiple steps or multiple separate etalon filters. The outputs from the etalon filter 20 are input to respective photodetectors 16a, 16b to convert the laser from an optical signal to an electrical signal. The converted electrical signals are input to an amplifier circuits 18a, 18b. The outputs from amplifier circuits 18a, 18b are converted from an analog signal to a digital signal by A/D converter 26 and input to controller 40.

The temperature of the TEC 30 and laser chip 12 are monitored by a sensor, such as for example thermistor 44, and the temperature value is input to controller 40. In accordance with the present invention, the controller 40 is adapted to utilize both etalon path signals, i.e., the paths that pass through the etalon 20, to determine the frequency of output 11 and, along with the reference path signal, i.e., the path that is output directly from the laser chip 12 without passing through the etalon filter 20, to adjust the output 11 accordingly by causing TEC driver 32 to vary the temperature of TEC 30. Additionally, in accordance with the present invention, controller 40 is adapted to compensate for variations in the etalon's optical characteristics caused by temperature changes in the etalon.

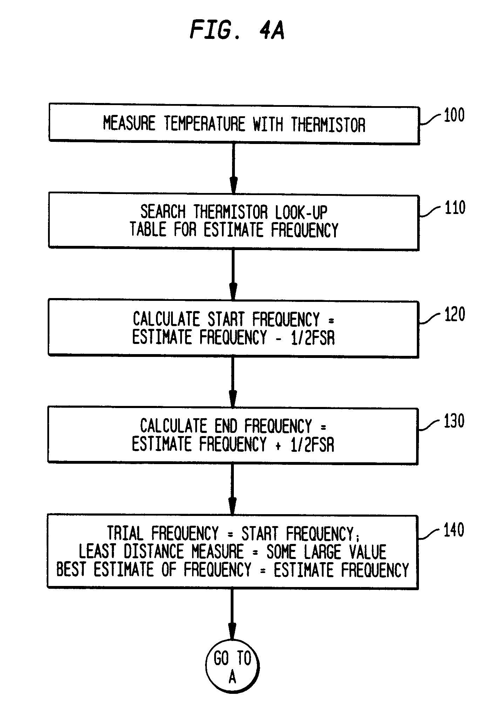

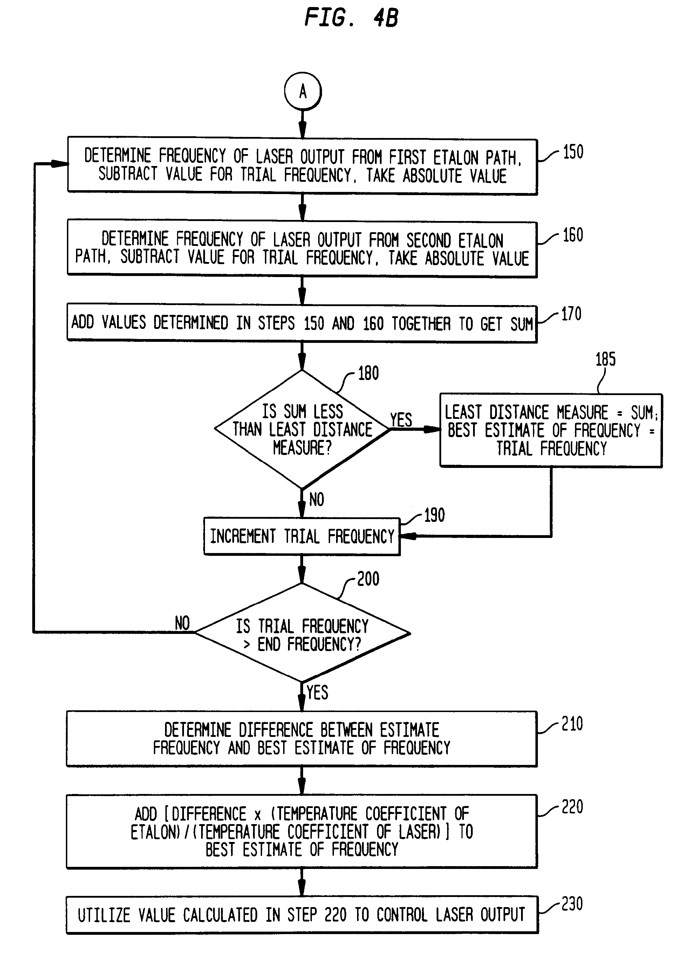

The operation of the circuit of Fig. 3 will be further described with reference to the flowchart of Fig. 4, which illustrates a method for measuring a laser wavelength performed by controller 40 in accordance with the present invention. Referring to Fig. 4A, in step 100, the temperature of the laser chip 12 is measured by thermistor 44 and input to controller 40. In step 110, controller 40 references a look-up table stored in memory device 50 to determine an estimate of the output frequency based on the temperature of laser chip 12. The values in the look-up table are defined during the calibration of laser chip 12 based on the response of laser chip 12.

It should be understood that the wavelength vs. temperature output of laser chip 12 may vary over time as laser chip 12 ages. Thus, as the laser chip 12 ages, the values in the look-up table may no longer be accurate. To overcome this problem, the look-up tables can be supplemented by controller 40, such as for example by a "learning" algorithm, by using historical statistical data to predict and adapt to variations in the laser chip 12 as it ages.

In step 120, a starting frequency is calculated by subtracting one-half of a free spectral range, i.e., approximately 50 GHz, from the estimate frequency found in step 110. In step 130, an ending frequency is calculated by adding one-half of a free spectral range, i.e., approximately 50 GHz, to the estimate frequency. The starting frequency and ending frequency are used to define a starting point and ending point, respectively, for searches of an etalon look-up table, stored in memory device 50, as further described below.

In step 140, a first variable Trial Frequency is set to the start frequency determined in step 120, a second variable Least Distance Measure is set to some large value outside the range of the end frequency determined in step 130, and a third variable Best Estimate of Frequency is set to the estimate frequency.

Referring to Fig. 4B, in step 150, the frequency of the laser output 11 as determined by the first etalon path 35 is determined by measuring the normalized etalon output and searching the etalon look-up table stored in memory device 50 to determine the corresponding frequency of the laser based on the etalon response curve. The values in the etalon look-up table are defined during the calibration and testing of the optical package based on the response curve of etalon 20. The value for Trial Frequency is subtracted from the determined laser frequency and the absolute value of the result is taken.

In step 160, the frequency of the laser output 11 as determined by the second etalon path 25 is determined by measuring the normalized etalon output and searching the etalon look-up table stored in memory device 50 to determine the corresponding laser frequency based on the response curve of the second etalon path. The value for Trial Frequency is subtracted from the determined frequency and the absolute value of the result is taken. As noted above, the search for the corresponding frequencies in the etalon look-up table are limited by the starting frequency as determined in step 120 and the ending frequency as determined in step 130. This is because, as shown in Fig. 2, the etalon response curves are infinite waveforms and thus will have many different frequencies associated with each normalized etalon output. By limiting the search of the etalon look-up table based on an estimate frequency from the temperature of the laser chip 12 (steps 100-120), the system is assured of determining the appropriate corresponding laser frequency from the look-up table.

In step 170, the value determined in step 150 for the first etalon path and the value determined in step 160 for the second etalon path are added together. In step 180, it is determined if sum of the values determined in steps 150 and 160 is less than the value for the Least Distance Measure. If the sum is less than the value for the Least Distance Measure, then in step 185 the value for the Least Distance Measure is updated to be the value of the sum determined in step 170 and the value for Best Estimate of Frequency is set to the value of Trial Frequency.

Once the variables Least Distance Measure and Best Estimate of Frequency have been updated in step 185, or if the sum determined in step 170 is not less than the value for Least Distance Measure, in step 190 the value for Trial Frequency is incremented. Preferably, the value for Trial Frequency is incremented in steps of approximately 500 MHz to I GHz.

In step 200, it is determined if the value for Trial Frequency is greater than the value for the ending frequency as determined in step 130. If the value for Trial Frequency is not greater than the value for the ending frequency, then the method returns to step 150 for continued processing. If the value for Trial Frequency is greater than the value for the ending frequency, indicating the full range of the look-up table, as defined by the starting frequency and ending frequency, has been searched, in step 210 the difference between the estimate frequency from step 110 and the value for the Best Estimate of Frequency determined in step 185 is determined. In step 220, the difference between the estimate frequency and the value for the Best Estimate of Frequency calculated in step 210 is multiplied by the ration of the temperature coefficient of the etalon to the temperature coefficient of the laser and added to the Best Estimate of Frequency. By utilizing the difference calculated in step 210 as an offset, a more accurate determination of the laser output frequency is provided. This offset, along with the temperature coefficient of the laser and the etalon, corrects for temperature discrepancies caused by aging of the laser chip 12 and ambient variations. In step 230, controller 40 utilizes the value calculated in step 220 to determine whether the output of laser chip 12 requires adjustment by varying the temperature of TEC 30. Accordingly, a self-correction for the etalon, due to aging, etc., being at a temperature different from the temperature when the look up table was initially populated with data, is provided.

Thus, in accordance with the present invention, the determination of the wavelength of a laser output in a multi- or stepped-etalon laser wavelength stabilization system is performed based on signals from each etalon path in the system, thereby compensating for subsequent changes in the optical characteristics of the etalons caused by varying temperatures. A corrective offset for the measured frequency of the laser output is determined based on values measured by each etalon and values previously stored in a look-up table. The frequency measurement is then adjusted by the determined offset to provide a more accurate determination of the laser frequency.

While the invention has been described as being implemented with a laser chip 12, it is to be understood that the invention is not so limited and may be used with any type of laser source as is known in the art, such as for example an array of lasers, a DFB laser, a distributed Bragg reflector (DBR) laser, a Fabry-Perot laser, etc. Additionally, the invention may be used with all temperature sensitive/wavelength sensitive elements, such as for example etalons, interference filters (lowpass, bandpass, and highpass), multiple grouping of filters (bandnotch), gratings, and the like.

Reference has been made to embodiments in describing the invention. However, additions, deletions, substitutions, or other modifications which would fall within the scope of the invention defined in the claims may be implemented by those skilled in the art and familiar with the disclosure of the invention without departing from the spirit or scope of the invention. Also, although the invention is described as implemented by a programmable controller, preferably a microprocessor running a software program, it may be implemented in hardware, software, or any combination of the two. All are deemed equivalent with respect to the operation of the invention. Accordingly, the invention is not to be considered as limited by the foregoing description, but is only limited by the scope of the appended claims.

## Claims

1. A method for tuning a laser output from a laser source in a temperature tuned laser system, said method comprising the steps of:
determining a first frequency of said laser output based on an optical response of a first optical filter to said laser output;
determining a second frequency of said laser output based on an optical response of a second optical filter to said laser output;
determining a control signal based on said first frequency and said second frequency; and
tuning said laser device based on said control signal.

2. The method according to claim 1, wherein before said step of determining a first frequency, said method comprises:
determining an estimate frequency for said laser output, wherein said first and second frequency are determined based on said estimate frequency.

3. The method according to claim 2, wherein said step of determining an estimate frequency further comprises:
measuring a temperature of said laser source, said first optical filter and said second optical filter; and
determining said estimate frequency based on said measured temperature of said laser source, said first optical filter and said second optical filter.

4. The method according to claim 3, wherein said step of determining said estimate frequency further comprises:
referencing a look-up table store in a memory device to determine said estimate frequency.

5. The method according to claim 2, wherein said steps of determining a first and second frequency further comprise:
referencing a look-up table stored in a memory device to determine said first and second frequency based on said optical response of said first and second optical filters to said laser output, respectively.

6. The method according to claim 5, wherein said step of referencing said look-up table further comprises:
determining a start frequency for said look-up table based on said estimate frequency; and
determining an end frequency for said look-up table based on said estimate frequency,
wherein said look-up table is referenced between said start frequency and said end frequency to determine said first and second frequency.

7. The method according to claim 6, wherein said step of determining a control signal further comprises:
setting a best estimate for said laser output to said estimate frequency;
determining a first difference between said first frequency and a trial frequency;
determining a second difference between said second frequency and said trial frequency;
summing an absolute value of said first difference and said second difference; and
determining if said sum is less than a predetermined frequency.

8. The method according to claim 7, wherein said trial frequency is said start frequency.

9. The method according to claim 7, wherein said predetermined frequency is greater than said end frequency.

10. The method according to claim 7, wherein if said sum is less than said predetermined frequency, said method further comprises:
setting said predetermined frequency to said sum;
setting said best estimate to said trial frequency;
incrementing said trial frequency; and
determining if said trial frequency is greater than said end frequency.

11. The method according to claim 7, wherein if said sum is not less than said predetermined frequency, said method further comprises:
incrementing said trial frequency; and
determining if said trial frequency is greater than said end frequency.

12. The method according to claim 10 or 11, wherein said trial frequency is incremented between approximately 500 MHz and 1 GHz.

13. The method according to claim 10 or 11, wherein if said trial frequency is not greater than said end frequency, said method further comprises:
repeating said steps of determining a first frequency and a second frequency of said laser output, determining a first and second difference, summing an absolute value of said first and second difference, setting said best estimate to said trial frequency; and incrementing said trial frequency until said trial frequency is greater than said end frequency.

14. The method according to claims 10 or 11, wherein if said trial frequency is greater than said end frequency, said step of determining a control signal further comprises:
determining a difference between said estimate frequency and said best estimate;
multiplying said difference between said estimate frequency and said best estimate by a predetermined constant to obtain a result; and
adding said result to said best estimate to obtain said control signal.

15. The method according to claim 14, wherein said predetermined constant is the ratio of a temperature coefficient of said first and second optical filters to a temperature coefficient of said laser source.

16. The method according to claim 1, wherein said step of tuning said laser device comprises:
tuning said laser device by varying a temperature of said laser source using said control signal.

17. The method according to claim 1, wherein said first optical filter is a first etalon, and said second optical filter is a second etalon.

18. The method according to claim 1, wherein said first optical filter is a first portion of an etalon, and said second optical filter is a second portion of said etalon, said first portion of said etalon having a different length than said second portion of said etalon.

19. A method for determining a frequency of a laser output from a laser source comprising the steps of:
determining a first frequency of said laser output based on an optical response of a first optical filter to said laser output;
determining a second frequency of said laser output based on an optical response of a second optical filter to said laser output; and
determining said frequency of said laser output based on said first frequency and said second frequency.

20. The method according to claim 19, wherein before said step of determining a first frequency, said method comprises:
determining an estimate frequency for said laser output, wherein said first and second frequency are determined based on said estimate frequency.

21. The method according to claim 20, wherein said step of determining an estimate frequency further comprises:
measuring a temperature of said laser source; and
determining said estimate frequency based on said measured temperature of said laser source.

22. The method according to claim 21, wherein said step of determining said estimate frequency further comprises:
referencing a look-up table store in a memory device to determine said estimate frequency.

23. The method according to claim 21, wherein said step of determining a first and second frequency further comprise
referencing a look-up table stored in a memory device to determine said first and second frequency based on said optical response of said first and second optical filters to said laser output, respectively.

24. The method according to claim 23, wherein said step of referencing said look-up table further comprises:
determining a start frequency for said look-up table based on said estimate frequency; and
determining an end frequency for said look-up table based on said estimate frequency,
wherein said look-up table is referenced between said start frequency and said end frequency to determine said first and second frequency.

25. The method according to claim 24, wherein said step of determining said frequency of said laser output further comprises:
setting a best estimate for said laser output to said estimate frequency;
determining a first difference between said first frequency and a trial frequency;
determining a second difference between said second frequency and said trial frequency;
summing an absolute value of said first difference and said second difference; and
determining if said sum is less than a predetermined frequency.

26. The method according to claim 25, wherein said trial frequency is said start frequency.

27. The method according to claim 25, wherein said predetermined frequency greater than said end frequency.

28. The method according to claim 25, wherein if said sum is less than said predetermined frequency, said method further comprises:
setting said predetermined frequency to said sum;
setting said best estimate to said trial frequency;
incrementing said trial frequency; and
determining if said trial frequency is greater than said end frequency.

29. The method according to claim 25, wherein if said sum is not less than said predetermined frequency, said method further comprises:
incrementing said trial frequency; and
determining if said trial frequency is greater than said end frequency.

30. The method according to claim 28 or 29, wherein said trial frequency is incremented between approximately 500 MHz and 1 GHz.

31. The method according to claim 28 or 29, wherein if said trial frequency is not greater than said end frequency, said method further comprises:
repeating said steps of determining a first frequency and a second frequency of said laser output, determining a first and second difference, summing an absolute value of said first and second difference, setting said best estimate to said trial frequency; and incrementing said trial frequency until said trial frequency is greater than said end frequency.

32. The method according to claims 28 or 29, wherein if said trial frequency is greater than said end frequency, said step of determining said frequency further comprises:
determining a difference between said estimate frequency and said best estimate; and
adding said difference between said estimate frequency and said best estimate to said best estimate to obtain said frequency of said laser output.

33. The method according to claim 19, wherein said first optical filter is a first etalon, and said second optical filter is a second etalon.

34. The method according to claim 19, wherein said first optical filter is a first portion of an etalon, and said second optical filter is a second portion of said etalon, said first portion of said etalon having a different length than said second portion of said etalon.

35. A laser control system comprising:
a laser source for producing a laser output;
a first optical filter through which a first portion of said laser output passes;
a second optical filter through which a second portion of said laser output passes; and
a controller adapted to determine a frequency of said laser output based on an optical response of said first optical filter and said second optical filter to said laser output.

36. The laser control system according to. claim 35, wherein said laser source is a laser chip.

37. The laser control system according to claim 35, further comprising:
a temperature device for controlling the temperature of said laser source, said temperature device adapted to vary a temperature of said laser source to adjust said laser output from said laser source,
wherein said controller is further adapted to determine a control signal based on said determined frequency of said laser output and output said control signal to said temperature device, said temperature device in response to said control signal varying said temperature of said laser source.

38. The laser control system according to claim 37, wherein said temperature device is a thermo-electric cooler (TEC).

39. The laser control system according to claim 38, further comprising:
a driver which receives said control signal from said controller and in response outputs a signal which varies said temperature of said laser source.

40. The laser control system according to claim 35, wherein said first optical filter is a first etalon, and said second optical filter is a second etalon.

41. The laser control system according to claim 35, wherein said first optical filter is a first portion of an etalon, and said second optical filter is a second portion of said etalon, said first portion of said etalon having a different length than said second portion of said etalon.

42. The laser control system according to claim 35, further comprising:
a sensor to measure a temperature of said laser source; and
a memory device for storing a look-up table,
wherein said controller is adapted to reference said look-up table stored in said memory and determine an estimate of said frequency for said laser output based on said measured temperature.

43. The laser control system according to claim 42, wherein said controller is further adapted to determine a first frequency of said laser output based on an optical response of a first optical filter to said laser output and determine a second frequency of said laser output based on an optical response of a second optical filter to said laser output, wherein said control signal is determined based on said first frequency and said second frequency.

44. The laser control system according to claim 43, further comprising:
an optical filter look-up table stored in said memory device,
wherein said controller is adapted to reference said optical look-up table stored in said memory device to determine said first and second frequency and determine said control signal based on said determined first and second frequency.

45. The laser control system according to claim 35, wherein said controller includes a processor.

46. The laser control system according to claim 45, wherein said processor includes a microprocessor.
